Europäisches Patentamt

European Patent Office

Office européen des brevets

(19)

(11) Numéro de publication: 0 374 022
A1

# (12) DEMANDE DE BREVET EUROPEEN

(21) Numéro de dépôt: 89403404.0

(22) Date de dépôt: 08.12.89

(51) Int. Cl.5: G02F 1/015

(30) Priorité: 16.12.88 FR 8816618

(43) Date de publication de la demande:
20.06.90 Bulletin 90/25

(84) Etats contractants désignés:
DE GB IT NL SE

(71) Demandeur: THOMSON-CSF
51, Esplanade du Général de Gaulle
F-92800 Puteaux(FR)

(72) Inventeur: Rajbenbach, Henri
THOMSON-CSF SCPI Cédex 67
F-92045 Paris la Défense(FR)
Inventeur: Loiseaux, Brigitte
THOMSON-CSF SCPI Cédex 67
F-92045 Paris la Défense(FR)
Inventeur: Schnell, Jean-Philippe
THOMSON-CSF SCPI Cédex 67
F-92045 Paris la Défense(FR)
Inventeur: Huignard, Jean-Pierre
THOMSON-CSF SCPI Cédex 67
F-92045 Paris la Défense(FR)

(74) Mandataire: Grynwald, Albert et al
THOMSON-CSF SCPI
F-92045 PARIS LA DEFENSE CEDEX 67(FR)

(54) Dispositif de modulation électro-optique et applications à un déflecteur optique ainsi qu'à un analyseur de spectres de fréquences.

(57) L'invention concerne un dispositif de modulation électro-optique comportant un élément (1) en matériau semiconducteur soumis à un champ électrique et éclairé par une source (5) de lumière d'une longueur d'onde traversant le matériau semiconducteur de l'élément (1).

L'invention est applicable à la réalisation de modulateurs, de déflecteurs et d'analyseurs de spectres de fréquences.

FIG.1

EP 0 374 022 A1

## DISPOSITIF DE MODULATION ELECTRO-OPTIQUE ET APPLICATIONS A UN DEFLECTEUR OPTIQUE AINSI QU'A UN ANALYSEUR DE SPECTRES DE FREQUENCES

L'invention concerne un dispositif de modulation électro-optique et son application à un déflecteur optique ainsi qu'à un analyseur de spectres de fréquences.

Les systèmes optiques de traitement du signal qui fonctionnent en éclairage cohérent nécessitent la réalisation de dispositifs de modulation en temps réel de la direction et/ou de l'intensité d'une onde lumineuse incidente. Une méthode attrayante consiste à faire varier le pas d'un réseau inscrit dans un matériau photosensible, puis de le relire par l'onde à traiter.

Les techniques employées pour faire varier le pas utilisent par exemple une modulation de la longueur d'onde ou de l'angle entre les deux faisceaux qui interfèrent dans des matériaux électro-optiques tel que cela est décrit dans l'article "Dynamic Beam Deflection using photorefractive gratings in $Bi_{12} SiO_{20}$ Crystals" de G. PAULIAT et al publié dans Journal Optical Society Am. B 3,2 (1986). Les systèmes de ces techniques ont pour inconvénients majeurs l'encombrement et le coût liés à l'utilisation de sources laser accordables en fréquence ou en direction.

Les dispositifs connus sous le nom de VGM LCD (Variable Grating Mode Liquid Crystal Devices) sont basés sur la possibilité de générer, à partir d'une onde incidente modulée en intensité, un réseau dont le pas dépend de l'intensité de cette onde. Ces dispositifs fonctionnent par réorientation moléculaire périodique de domaines dans un cristal liquide soumis à une tension électrique continue tel que cela est décrit dans l'article : "Variable grating mode liquid crystal device for optical processing and computing" de B.H. SOFFER et al publié dans Mol. Crystal liquid device 70, 145 de 1981. Les inconvénients principaux de tels dispositifs sont :

- (i) un temps de réponse très lent d'environ 1 seconde ;

- (ii) une durée de vie limitée du fait de l'utilisation de tensions continues sur le cristal liquide ;

- (iii) une difficulté d'intégration avec les systèmes électro-optiques existants (lasers semiconducteurs, circuits VLSI).

L'invention fournit des systèmes de nature différente et fonctionnant sur un principe différent.

L'invention concerne donc un dispositif de modulation électro-optique caractérisé en ce qu'il comporte un élément en matériau semiconducteur soumis à un champ électrique et éclairé par une source de lumière cohérente ou incohérente d'une longueur d'onde traversant le matériau semiconducteur de l'élément.

L'invention concerne également un dispositif de modulation électro-optique, caractérisé en ce qu'il comporte au moins un analyseur de polarisation optique associé à une de ses faces principales.

L'invention concerne également différentes applications d'un tel dispositif. C'est ainsi que l'invention concerne un dispositif dans lequel l'élément comporte deux faces opposées sensiblement parallèles, caractérisé en ce que l'analyseur est associé à l'une de ces faces et qu'un polariseur est associé à l'autre face.

Selon une autre application, l'invention concerne un analyseur de spectre de fréquences appliquant le dispositif de modulation électro-optique , caractérisé en ce qu'il comporte une série d'éléments photodétecteurs couplée optiquement à l'analyseur.

Les différents objets et caractéristiques de l'invention apparaîtront plus clairement dans la description qui va suivre faite en se référant aux figures annexées qui représentent :

- la figure 1, un dispositif de modulation selon l'invention ;

- la figure 2, une variante du dispositif de modulation selon l'invention ;

- la figure 3, une analyseur de spectre de fréquences selon l'invention ;

- la figure 4, un déflecteur de faisceau lumineux selon l'invention fonctionnant en transmission ;

- la figure 5, un déflecteur de faisceau lumineux selon l'invention fonctionnant en réflexion.

L'invention est basée sur un effet récemment mis en évidence en laboratoire comme cela est décrit dans l'article :"Visualization of Electrical Domains in Semi-Insulating GaAs : Cr and Potential use for Variable Grating Mode Operation" de H. RAJBENBACH et al publié dans Applied Physic Letters 53 (7) du 15 août 1988.

Cet effet permet de générer des réseaux de phase de pas variables dans le volume d'un matériau semiconducteur tel que du GaAs:Cr. Ce réseau de pas variable est lié à l'apparition d'un champ de charge d'espace périodique dans des cristaux éventuellement soumis à une illumination uniforme (cohérente ou incohérente) et à une tension électrique externe. Ce champ de charge d'espace, dont le pas dépend des caractéristiques de la tension appliquée, module par effet électro-optique la biréfringence du milieu et crée ainsi un réseau de phase de pas électriquement contrôlable.

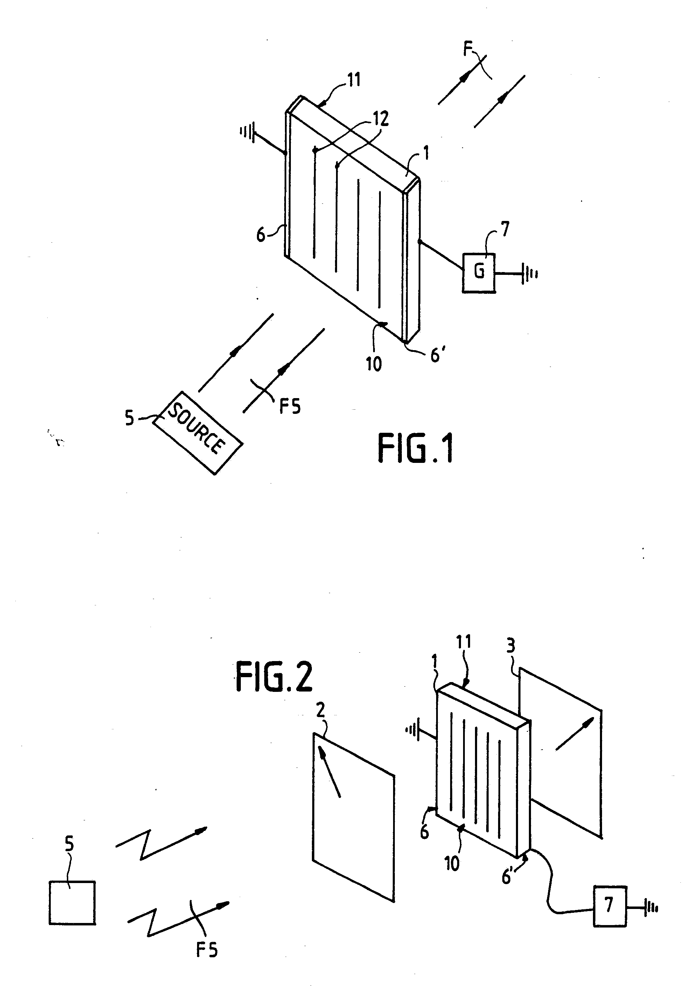

Selon l'invention, comme cela est représenté en figure 1, on prévoit donc pour moduler la lumière un élément 1 en matériau semiconducteur comportant deux faces principales parallèles 10 et 11. Sur deux côtés opposés de l'élément 1 sont prévues deux électrodes 6 et 6' connectées aux bornes d'une source de tension périodique 3 et permettant d'appliquer, à l'élément 1, un champ électrique parallèle au plan des faces 10 et 11. Une source lumineuse 5 transmet à la face 10 un faisceau lumineux F5 de longueur d'onde déterminée. Le matériau de l'élément 1 est transparent à cette longueur d'onde. Un réseau d'indices 12 est ainsi inscrit dans l'élément 1 et l'élément 1 recevant le faisceau F5 fournit un faisceau de sortie FM qui est modulé spatialement.

La fréquence du signal de tension appliqué aux électrodes 6 et 6' détermine le pas du réseau d'indice et détermine donc la nature de la modulation spatiale.

De plus, le dispositif de la figure 1 peut être appliqué à la déflexion de faisceau optique. Il suffit pour cela d'ajuster la valeur de la fréquence du champ électrique et donc d'agir sur la valeur du pas du réseau d'indices pour qu'il fonctionne en déflecteur.

La figure 2, représente un dispositif de modulation similaire à celui de la figure 1 possédant en plus un polariseur 2 associé (ou couplé optiquement) à la face 10 ainsi qu'un analyseur 3 associé à la face 11.

Le faisceau lumineux transmis à la face 10 est donc polarisé par le polariseur 2. Une rotation de polarisation due au réseau d'indice de l'élément 1 conduit au résultat que l'analyseur 3 permet de moduler en intensité le faisceau lumineux transmis par la face 11 de l'élément 1.

Si la source 4 fournit un faisceau de lumière polarisée, il est bien évident que le polariseur 2 n'est pas à prévoir.

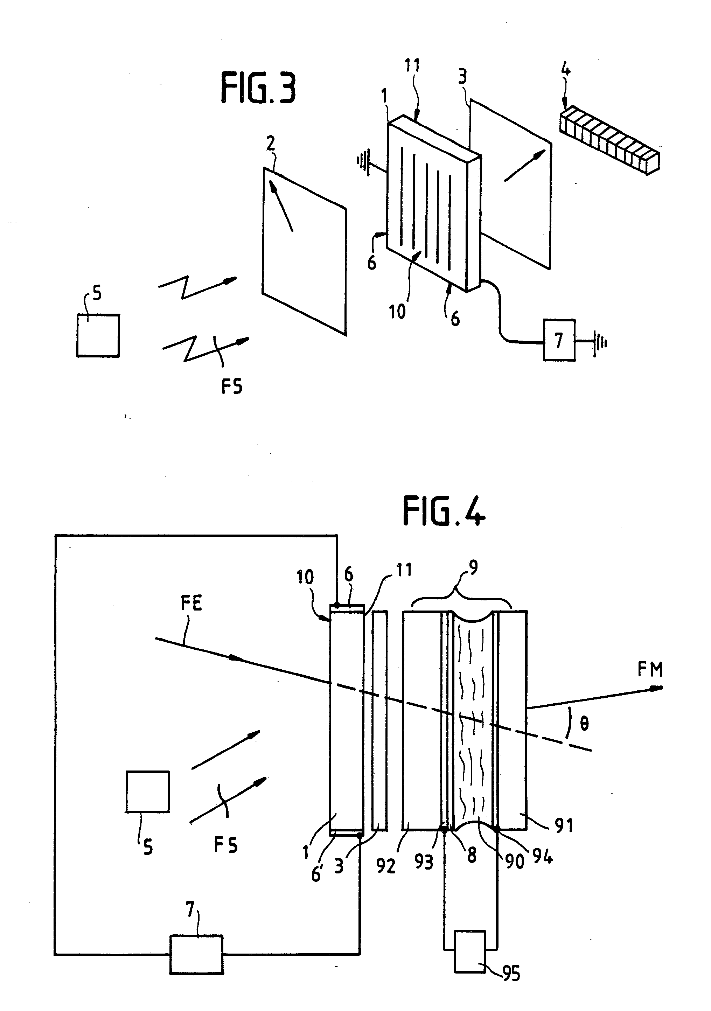

La figure 3 représente un analyseur de spectre de fréquences.

Cet analyseur comporte le dispositif de la figure 2 avec, combinée à ce dispositif, une barrette de détecteur photo-électrique 4.

Le signal de tension d'une fréquence déterminée induit, dans l'élément en matériau semiconducteur un réseau d'indice. Ce réseau d'indice agit sur le faisceau F5 comme cela a été décrit précédemment. La modulation spatiale de phase subie par le faisceau incident est transférée en modulation transverse d'intensité après traversée de l'analyseur. On obtient ainsi un figure d'illumination dont le pas (V,f) est contrôlé en temps réel. Cette figure d'illumination peut à son tour être transférée sur la barrette de photo-détecteur 4. La barrette de photo-détecteur 4 permet donc de détecter l'effet de modulation induite sur le faisceau lumineux par le réseau d'indice. Le pas du réseau d'indice étant fonction de la fréquence de champ électrique appliqué - donc de la fréquence de la source de tension - la modulation transmise à la barrette de photo-détecteur 4 traduit la valeur de la fréquence de la source de tension.

Le dispositif de la figure 3 est donc bien un analyseur de fréquence.

La figure 4 représente un déflecteur optique dans lequel on se propose de contrôler la direction d'une onde lumineuse cohérente.

Le déflecteur comporte :
- un élément 1 en matériau semiconducteur possédant deux électrodes 6 et 6' permettant d'appliquer un champ électrique périodique ;
- une source lumineuse (cohérente ou incohérente) éclairant une face 10 de l'élément 1 ;
- un polariseur 3 associé à la face 11 de l'élément 1 ;
- une cellule à cristal liquide 9 associée au polariseur 3 et constituée de deux lames transparentes 91 et 92 enserrant un matériau cristal liquide 90 avec une couche d'un matériau photo-conducteur recouvrant la lame 92 la plus proche du polariseur 3, cette couche de matériau photo-conducteur étant en contact avec le cristal liquide 90. En outre des électrodes 93 et 94 en matériau conducteur transparent (ITO) sont prévues de part et d'autre du cristal liquide pour la commande de la cellule à cristal liquide :
- un générateur de tension 7 connecté aux électrodes 6 et 6' ;
- un générateur de tension 95 connecté aux électrodes 93 et 94.

Une illumination uniforme (cohérente ou incohérente) induit un réseau de phase dont le pas est contrôlé en temps réel par le champ appliqué par les électrodes 6 et 6'. Le faisceau à défléchir FE est diffracté dans une direction choisie sous la commande du champ électrique appliqué et donc de la fréquence du signal de tension fourni aux électrodes par un générateur de tension.

En effet, le champ électrique appliqué à l'élément 1 par les électrodes 6 et 6' crée un réseau d'indice dans l'élément 1 éclairé uniformément par le faisceau F5 de lumière cohérente ou incohérente.

Un faisceau de lumière polarisée FE est dirigé sur la face 10 et est modulé par l'élément 1 et le polariseur 3. La couche de matériau photo-conducteur 8 est rendue conductrice dans des zones particulières dues à la modulation. Le générateur 95, appliquant une tension de commande aux électrodes 93 et 94, fournit un champ électrique dans les zones de la cellule à cristal liquide correspondant aux zones de la couche de matériau photo-conducteur rendues conductrices. On crée ainsi dans la cellule à cristal liquide un réseau de diffraction. Le faisceau lumineux FE, lorsqu'il atteint ce réseau de diffraction, est diffracté et donc dévié de sa direction d'un angle 0. La valeur de cet angle dépend du pas du réseau de diffraction et le pas du réseau de diffraction dépend de la fréquence du champ appliqué à l'élément semiconducteur 1.

On voit donc qu'en réglant la valeur de la fréquence du signal de tension appliqué par le générateur 7 aux électrodes 6 et 6', on règle la déflexion du faisceau FM.

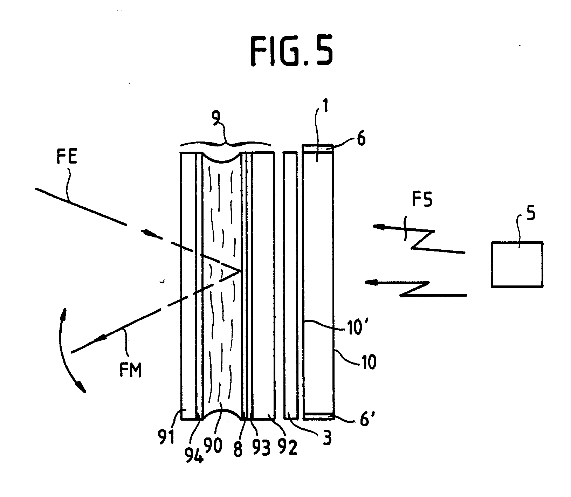

La figure 5 représente un déflecteur optique similaire au déflecteur de la figure 4 mais dont l'agencement permet un fonctionnement en réflexion au lieu d'un fonctionnement en transmission.

Sur la figure 5 on trouve :
- l'élément 1 en matériau semiconducteur, possédant ses deux électrodes 6 et 6' appliquant un champ électrique alternatif sous la commande d'un générateur de tension (non représenté) et éclairé sur sa face 10 par la source 5 de lumière cohérente ou incohérente ;
- un polariseur 3 associé à la face 10' de l'élément 1 ;
- une cellule de matériau électrooptique tel qu'un cristal liquide 9 avec ces lames de verre 91 et 92 enserrant le cristal liquide 90 et une couche d'un matériau photo-conducteur 8 en contact avec le cristal liquide sur la lame 92 la plus proche du matériau photo-conducteur ; la cellule 9 possède en outre des électrodes de commande transparentes.

Dans cette variante de réalisation, le matériau photo-conducteur 8 n'est pas transparent. Le déflecteur reçoit le faisceau FE, dont on veut commander la déflexion, par la lame 91 de la cellule à cristal liquide.

Un réseau de diffraction est inscrit dans la cellule à cristal liquide 9 comme cela a été décrit précédemment à l'aide de l'élément 1 et de la couche de matériau photo-conducteur.

Le faisceau lumineux FE est défléchi par diffraction à l'aide du réseau de diffraction réalisé dans la cellule à cristal liquide 9 et l'orientation du faisceau réfléchi FM est fonction de la fréquence du champ électrique appliqué à l'élément 1.

Les avantages de ces dispositifs par rapport à ceux habituellement utilisés sont liés à la simplicité d'obtention de pas variables dans des matériaux semiconducteurs ; ils sont par exemple ;
- un temps de réponse rapide ;
- un encombrement réduit ;
- une absence de source laser annexe pour l'inscription du réseau ;
- une utilisation potentielle sur une large bande spectrale.

Ces dispositifs trouvent des applications dans tout système où on a besoin de défléchir de façon dynamique un faisceau et notamment dans des systèmes nécessitant des interconnexions optiques reconfigurables et dans des systèmes de distribution de faisceaux optiques.

Il est à noter que l'élément 1 en matériau semiconducteur peut être en GaAs dopé ou non dopé ou en tout autre semiconducteur.

La tension électrique appliquée à l'élément 1 sera de préférence en dents de scie mais pourra être de toute autre forme, pulsée ou sinusoïdale.

Il est bien évident que la description qui précède n'a été faite qu'à titre d'exemple. D'autres variantes peuvent être envisagées sans sortir du cadre de l'invention. Les exemples de matériaux constituant l'élément semiconducteur 1 n'ont été fournis que pour illustrer la description.

## Revendications

1. Dispositif de modulation électro-optique caractérisé en ce qu'il comporte un élément (1) en matériau semiconducteur soumis à un champ électrique et éclairé par une source (5) de lumière cohérente ou incohérente d'une longueur d'onde traversant le matériau semiconducteur de l'élément (1).

2. Dispositif de modulation électro-optique selon la revendication 1, caractérisé en ce qu'il comporte au moins un analyseur (3) de polarisation optique associé à une de ses faces principales (11).

3. Dispositif selon la revendication 2, caractérisé en ce que l'élément (1) est de forme générale plane et que le champ électrique est appliqué selon une direction parallèle à une face principale (11) de cet élément (1).

4. Dispositif selon la revendication 1, caractérisé en ce que le rayonnement (F5) est transmis à une face principale (10 ou 11) de l'élément (1) selon une direction non parallèle à cette face.

5. Dispositif selon la revendication 3, dans lequel l'élément (1) comporte deux faces opposées (10, 11) sensiblement parallèles, caractérisé en ce que l'analyseur (3) est associé à l'une de ces faces (11) et qu'un polariseur (2) est associé à l'autre face (10).

6. Analyseur de spectre de fréquences appliquant le dispositif de modulation électro-optique selon l'une quelconque des revendications précédentes, caractérisé en ce qu'il comporte une série d'éléments photo-détecteurs (4) couplé optiquement à l'analyseur (3).

7. Déflecteur optique appliquant le dispositif de modulation électro-optique selon l'une des revendications 1 à 5, caractérisé en ce qu'il comporte un élément photo-conducteur (8) couplé optiquement à l'analyseur (3) ainsi qu'une cellule à matériau électro-optique (9) couplée elle-même optiquement à l'élément photo-conducteur (8).

8. Déflecteur optique selon la revendication 7, caractérisé en ce qu'il est constitué d'un matériau matériau électro-optique (90) enserré entre l'élément photo-conducteur (8) et un élément transparent (91), à la longueur d'onde du faisceau à défléchir et constituant un support d'électrode.

FIG.1

FIG.2

EP 0 374 022 A1

FIG.3

FIG.4

# FIG.5

Office européen
des brevets

**RAPPORT DE RECHERCHE EUROPEENNE**

Numero de la demande

EP 89 40 3404

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| D,X | APPL. PHYS. LETT., vol. 53, no. 7, 15 août 1988, pages 541-543; H. RAJBENBACH et al.: "Visualization of electrical domains in semi-insulating GaAs:Cr and potential use for variable grating mode operation" <br> * Abrégé; page 541, colonne 1, ligne 19 - colonne 2, ligne 6; page 542, colonne 1, ligne 24 - page 543, colonne 2, ligne 22; figures * <br> --- | 1-6 | G 02 F 1/015 |
| D,Y | MOL. CRYST. LIQ. CRYST., vol. 70, nos. 1-4, 1981, pages 1423-1439; B.H. SOFFER et al.: "Variable grating mode Liquid Crystal Device for Optical Processing and Computing" <br> * Page 1429, lignes 1-19; figure 5 * <br> ----- | 7,8 | |
| | | | **DOMAINES TECHNIQUES RECHERCHES (Int. Cl.5)** <br><br> G 02 F |

Le présent rapport a été établi pour toutes les revendications

| Lieu de la recherche | Date d'achèvement de la recherche | Examinateur |
|---|---|---|
| LA HAYE | 08-03-1990 | LOFFREDO A. |

EPO FORM 1503 03.82 (P0402)